# EUROPEAN PATENT SPECIFICATION

(11) **EP 0 650 456 B1**
(45) Date of publication and mention of the grant of the patent: **11.12.1996**
(21) Application number: 94905614.7
(22) Date of filing: 29.06.1993
(51) Int. Cl.: B65G 51/03, H01L 21/00

(54) **ARTICLE-HANDLING SYSTEM**
HANDHABUNGSSYSTEM FÜR ARTIKEL
SYSTEME DE MANUTENTION D'ARTICLES

(30) Priority: 15.07.1992 US 914765; 15.07.1992 US 914775; 22.06.1993 US 78380
(43) Date of publication of application: 03.05.1995
(73) Proprietor: MINNESOTA MINING AND MANUFACTURING COMPANY, St. Paul, Minnesota 55133-3427 (US)
(72) Inventor: SKOW, Lynn, R., Saint Paul, MN 55133-3427 (US); MOORE, Arthur, R., Saint Paul, MN 55133-3427 (US); DUNBAR, William, M., Saint Paul, MN 55133-3427 (US)
(74) Representative: Hilleringmann, Jochen, Dipl.-Ing.
(86) International application number: US9306152
(87) International publication number: WO9402396

(56) References cited:
- US-A- 3 411 830
- US-A- 3 761 002
- US-A- 3 890 508

## Description

The present invention relates to systems for handling and operating on articles. More particularly, the present invention relates to a system using a fluid for holding, moving, detecting, and operating on articles and for logic and control elements.

Many commercially available devices use gaseous and liquid fluids to inspect objects, sense objects, transport material, clamp material, or perform logic functions. Some examples are dimensional air gauges, interrupt able jet sensors, air conveyors, machining vacuum chucks, venturi-suction cup combinations, and fluidic logic modules. Many of these devices are fabricated in rigid plastic and metal configurations and are often attached to products and equipment with fasteners, by welding, gluing, or with other rigid attachment methods.

Devices such as air tables and conveyors which provide a cushion of air on which an article can float are well known. However, while the article can float on the air cushion or air bearing, additional external devices or forces must be used to hold, translate, rotate, detect, or otherwise operate on the article.

Transport tables which use directional air jets to transport articles also are known.

From US-A-3 761 002 there is known a fluid bearing having discrete holes formed by vortex restrictors. According to the embodiment of Figure 4 of US-A-3 761 002 the known device comprises three stacked layers, the middle one being provided with a curved passage leading to a round vortex chamber. The opening of the curved passage is oriented tangentially with respect to the vortex chamber. The upper layer is provided with a throughhole coaxially arranged with the vortex chamber and terminating in the outer working surface of the upper layer.

It is the object of the present invention to provide a system which supports and operates on an article which can act on an article at orientations other than above a horizontal surface.

This object is solved by an apparatus according to claim 1.

The present invention is an apparatus for handling and operating on an article. The apparatus includes a member having a working surface and at least one orifice which begins from an inlet, passes through the member, and has at least one outlet on the working surface. Fluid enters the member through the inlet, passes through the orifice, and exits through the outlet.

The member is a web made of a plurality of stacked layers which form a laminate. At least one layer has one or more orifices. The orifices can be oriented to cause the fluid exiting the orifices to create a lower pressure than the ambient pressure between the article and the working surface to cause the article to be held on the working surface.

The working surface comprises the outer major surface of one of the outer stacked layers. Each layer is provided with at least one throughhole connecting the major surfaces thereof and extending substantially perpendicularly thereto, the openings of each throughhole being in the respective plane of the major surfaces of each respective layer.

A fluid source is connected to the orifice inlets. The fluid passing through the orifices operates on an article on the working surface. This operation could simply be holding the article in place on the working surface. Alternatively, the operation could include transporting the article along or rotating the article on the working surface by selectively directing and shaping the outlets of the orifices. In other alternative embodiments, the apparatus can serve as fluidic logic elements or as inspection transducers, or can be used to sense the presence of an article. Additionally, the apparatus can be used to convert an existing surface into a system for handling and operating on an article with minimal increase in the thickness of the existing surface.

Since the system according to the invention is fabricated in a layered configuration, it can be quickly and effectively attached to products and equipments.

The invention will be described in more detail with reference to the attached drawing in which
Figure 1A is a cross-sectional side view of an apparatus for operating on an article according to an embodiment of the present invention configured to hold or transport an article,
Figure 1B is a top view of the apparatus of Figure 1A,
Figure 1C is an end cross-sectional view of the apparatus of Figure 1A,
Figure 2 is an end cross-sectional view of an alternative embodiment of the apparatus of Figures 1A to 1C,
Figure 3 is a schematic view of a horizontal, one-dimensional, transport path,
Figure 4 is a schematic view of a downwardly vertical transport path,
Figure 5 is a schematic view of an upwardly vertical transport path,
Figure 6 is a schematic view of an upside-down, horizontal, one-dimensional transport path,
Figures 7A and 7B are cross-sectional views of an apparatus for handling and operating on an article according to another embodiment of the present invention configured to transport an article in two directions,
Figure 8 is a perspective view of a transport track incorporating the apparatus of Figure 1,
Figures 9, 10, and 11 are cross-sectional views of tape winders incorporating the apparatus of Figures 1 and 2,
Figure 12 is a partial cross-sectional view of one embodiment of an apparatus for operating on an article configured to rotate an article,
Figure 13 is a top view of the apparatus of Figure 12,
Figure 14 is a schematic view of a curved, two-dimensional transport path,
Figure 15 is a schematic view of a helical, three-dimensional transport path,
Figure 16 is a cross-sectional view of an apparatus for operating on an article according to the present invention configured to hold an article,
Figure 17 is a perspective view of a suction cup incorporating the apparatus of Figure 16,
Figure 18 is a perspective view of a process clamp incorporating the apparatus of Figure 16,
Figures 19A-19G are top views of layers used to form the apparatus of the embodiment of Figure 16,
Figure 20 is a cross-sectional view of an apparatus according to another embodiment of the present invention configured to provide a pneumatic switching article,
Figure 21 is a schematic view of a fluidic logic element incorporating apparatus to provide a logic and control function,
Figures 22 and 23 are cross-sectional views of apparatus according to another embodiment of the present invention configured to serve as inspection transducers,
Figures 24 and 25 are cross-sectional views of apparatus for handling and operating on an article according to another embodiment of the present invention configured to serve as article applicators,
Figures 26A, 26B, 27A, 27B, and 28 are cross-sectional views of apparatus according to embodiments of the present invention configured to serve as article and proximity sensors,
Figure 29A is a perspective view of an article sensor incorporating the apparatus of Figure 26, and
Figure 29B is a perspective view of an article sensor incorporating the apparatus of Figure 28.

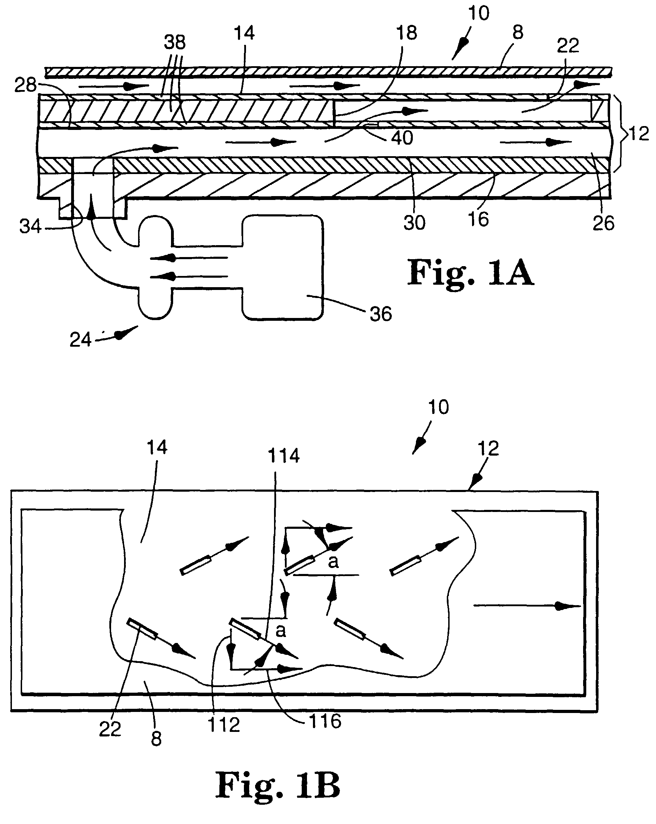

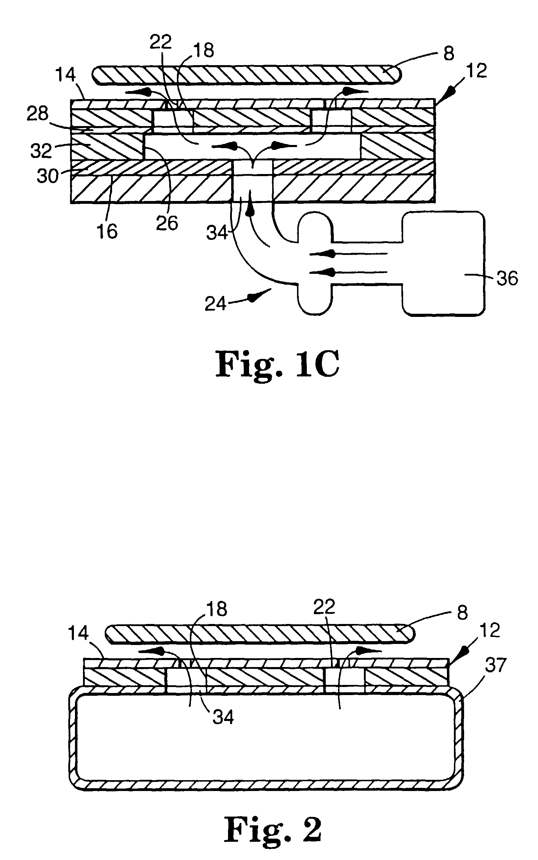

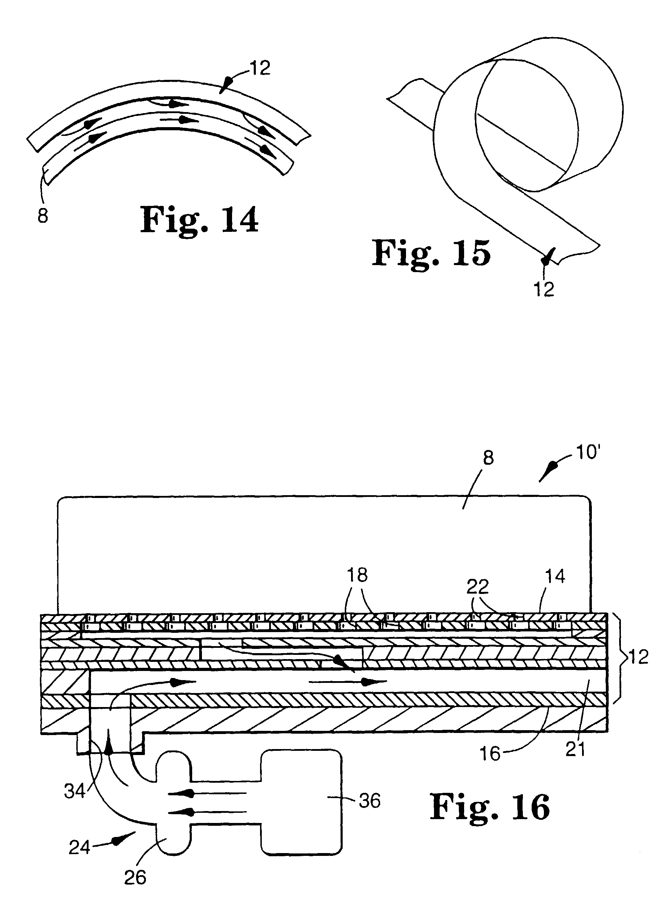

The system 10 handles and operates on an article 8 and can be easily adhered to an existing surface. The system 10 can operate with various working fluids although illustrated embodiments are described as using air. As shown in Figures 1 and 2, the system 10 includes a member 12, having a working surface 14 and an opposing bottom surface 16. As shown, the member 12 is flexible. At least one orifice 18 begins from at least one inlet 34, passes through the member 12, and has outlets 22 on the working surface 14. Fluid, such as air, water, inert fluorocarbons, and various other gases and gas mixtures, enters the member 12 through the inlet 34, passes through the orifice 18, and exits through the outlets 22. In embodiments involving contact of the article 8, such as shown in Figure 16 and described below, the orifice 18 continues past the outlet 22 to create suction.

The outlets 22 are the outlet for a conduit assembly 24 which is in fluid communication with the inlet 34 through the orifice 18. Fluid from each outlet 22 exits the member 12 at a predetermined angle and direction selected in combination with the desired function of the system 10. Fluid exiting the outlets 22 flows between the working surface 14 and the article 8 and the fluid flow direction from individual outlets 22 can vary from the directional path of the article 8.

The conduit assembly 24 includes a supply manifold 26 which can be formed as part of the member 12, as shown in Figures 1 and 2, or mounted to the bottom surface 16 of the member 12. In Figure 1C, the supply manifold 26 includes a channel defined by a top wall 28, a bottom wall 30, and side walls 32. The inlet 34 introduces fluid into the supply manifold 26 for distribution through the orifices 18 and outlets 22. A fluid source 36 is connected to the inlet 34. The fluid source 36 can be a compressor which supplies air under pressure to the conduit assembly 24. The pressurized air exits through the outlets 22 in a jet-like flow against the article 8. The alternative embodiment of Figure 2 does not use the supply manifold 26. Instead, a member 12 is mounted directly to a pressure vessel or plenum chamber 37 with inlets 34 communicating with the orifices 18 and outlets 22 in the member 12.

The fluid passing through the orifices 18 handles and operates on an article 8 on the working surface 14. The operation can be varied by changing the system characteristics. Selecting the pattern, direction, angle, shape, and length of the outlets 22 and the thickness of the layers 38 in combination with the fluid pressure and the article properties determines the operation. Particularly, the operation can be altered by changing the angle a, shown in Figure 1B, at which the fluid exits the outlets 22. The directional component 116 of the air flow contributes to both the pressure differential and transport of the article 8 while the cross-directional component 112, perpendicular to the directional component 116, contributes only to pressure differential. The cross-directional component 112 and the directional component 116 combine to yield the flow direction 114. When the fluid exits with no cross-directional component 112 the system 10 transports articles 8 with less pressure differential than if there were a cross-directional component. When the fluid exits with some cross-directional component 112, the system 10 transports articles 8 with increased pressure differential. When the fluid exits with no directional component 116, the system 10 holds articles 8 with no transport.

The jet-like air flow exiting the orifices 18 through the outlets 22 creates a controllable gap between the working surface 14 of the member 12 and a bottom surface of the article 8. The gap is established by balancing and maintaining equilibrium among the forces, including gravity, on the article 8.

According to the Bernoulli principle, as the air velocity increases, its pressure is reduced from that of the surrounding fluid moving at a lower velocity. The velocity difference causes a pressure difference. An object placed between the high and low velocity fluid will tend to be forced toward the higher velocity fluid until equilibrium is reached. Where a uniform fluid flow is forced between a stationery working surface and a movable object, a uniform force will be exerted on the object toward the working surface. The object will not contact the working surface if the object has an area-to-weight ratio large enough so that the force from the air jets exceeds the gravitational and other forces and the product of the surface area of the article and the pressure between the article and the working surface must exceed the weight of the article.

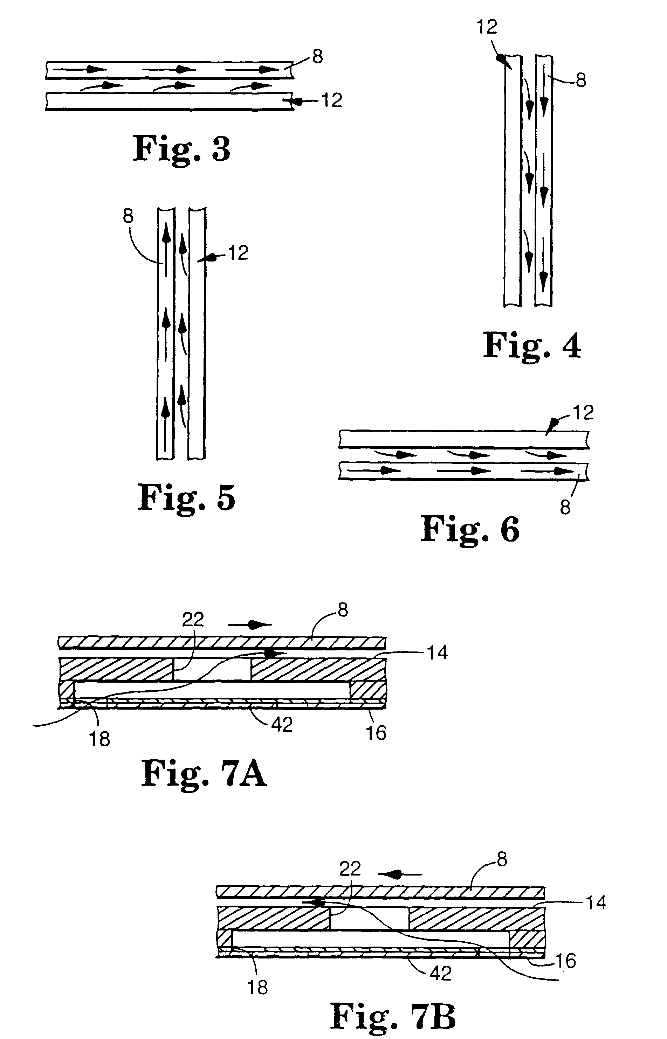

As long as the fluid flow is uniform and the article 8 has a sufficiently large area-to-weight ratio, a uniform pressure is exerted on the article toward the working surface. Minimum area-to-weight ratios of 30 x 10⁻³ cm²/gm are preferred, although an approximately 10⁻³ cm²/gm ratio is acceptable for atmospheric applications. Therefore, the system 10 can operate when the member 12 and the article 8 are horizontal with the article 8 on top of the working surface 14 of the member 12 (Figure 3), as well as vertical (Figures 4 and 5), with the article 8 underneath the working surface 14 of the member 12 (Figure 6), or at any orientation along the 360° circle of positions. The system 10 is orientation independent.

The member 12 preferably is a web. At least one layer 38 has one or more orifices. In a typical embodiment, three layers 38 are used: a first layer through which the fluid enters, a second layer which establishes the direction of the fluid, and a third layer through which the fluid exits. The layers 38 can be as thin as, for example, about 0.01 mm and can be any flexible material. The layers 38 can be joined or laminated by bonding, welding, or using adhesives. Also, the layers 38 can simply be pressed together without bonding. The layers 38 can be pre-laminated with an adhesive on the outermost bottom layer and the member 12 can be attached like adhesive tape to a mounting surface which has ports to communicate with those in the bottom of the member 12. A release layer, such as silicone treated paper, may optionally be included to facilitate storage and unwinding of the article.

The layers 38 can be formed of plastics, metals, ceramics, or composite materials. To prevent static charge build-up on the working surface 14, the working surface 14 can be metallic or conductive plastic. Additionally, the transport fluid can be ionized to facilitate the transport of materials that might involve static charge build-up. The openings 40 in each layer 38 can be formed by any known method including punching, drilling, or stamping. The openings 40 can be perpendicular to or at acute angles with the surface of the layer. Also, the orifices 18 formed when the layers 38 are stacked need not be straight or linear and can have any desired shape. Outlets with areas less than 0.0036 cm² have been fabricated. Air supplied at 4.25 x 10⁻² m³/min (1.5 cfm) and 140 gr/cm² (2.0 psi) to these outlets transport articles at 760 cm/s.

As is shown in the Figures, the outlet can create an angular, non-linear, stepped path for the fluid. The outlet area can have any shape. It could be rectangular, round, oval, or any regular or irregular polygon and need not be dictated by the formula for commonly-drilled holes with a circular cross section bit which, when drilling at an acute angle with the plane of the working surface, form an outlet at the working surface having an oval cross section with a length to width ratio governed by the drilling angle α as expressed in the equation l/w = 1/sin α. Thus, the outlet 20 can extend through the working surface 16 to deliver fluid to the working surface at an effective angle of less than 20° with an outlet having a length to width ratio less than 2.9. The outlet length to width ratio is not limited by the drilling angle formula and length to width ratios much less than dictated by the formula can be achieved. Thus, for example, the effective angle can be less than 15° and the length to width ratio less than 3.8, the effective angle can be less than 10° and the length to width ratio less than 5.7, and the effective angle can be less than 5° and the length to width ratio less than 11.4.

In a modification shown in Figures 7A and 7B, a movable wiper lamination layer 42 can open and close the orifices 18 to turn on and off the fluid jets passing through the orifices. The wiper lamination layer 42 also can reverse the direction of fluid flow through the orifices 18. As the wiper lamination layer 42 moves from the position in Figure 7A to that in Figure 7B, the fluid inlet is switched to change the fluid jet direction.

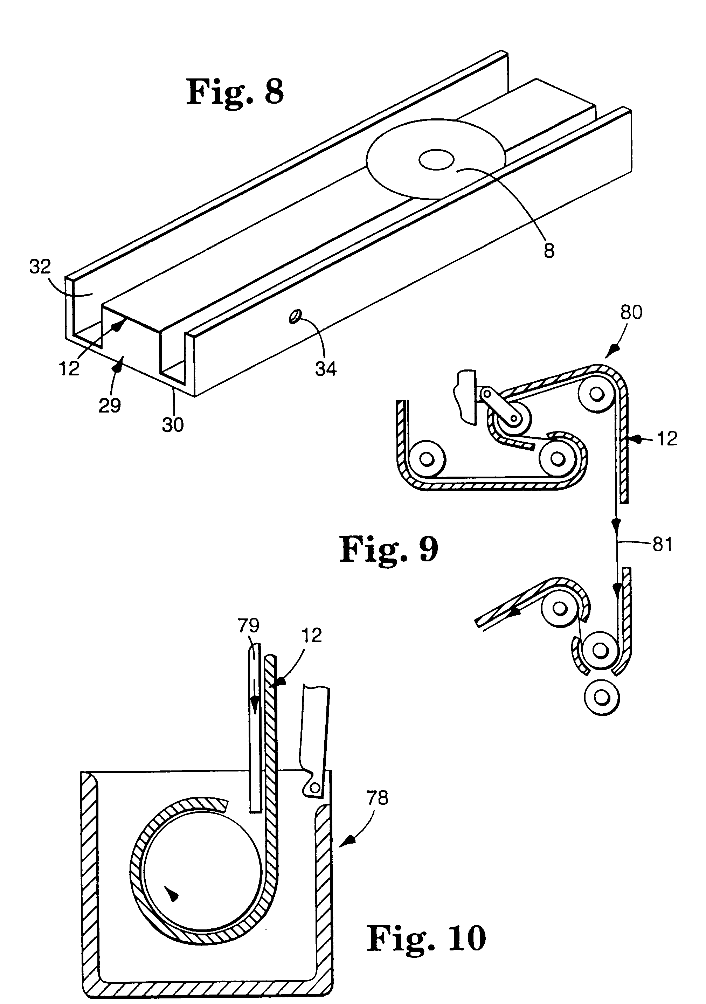

The system 10 has numerous uses. The operation includes moving or holding an article 8 without contacting the article as illustrated in Figures 1, 2, and 8-13. The article is simply transported without contact. The transport of high area-to-weight ratio articles 8 is accomplished while holding the article adjacent the working surface 14. The system 10 can transport disks, such as shown in Figure 8. Similarly, the system 10 can be used to pick up an article 8, such as a disk, without contacting the article, and transporting the article to another location at which a separate system 10 can receive the article without contact. This transportation can be accomplished either by using the fluid streams of the system 10 or, conventionally, by physically moving the system 10 itself. The system 10 transports webs such as tapes, which are compliant and have a high area-to-weight ratio, by threading and winding the tape ends through a tape winding apparatus or end product such as a cassette. The jet-like air flow exiting the outlets 22 supports the article 8 and has sufficient force to move the article 8 in the direction of the ejected air. The article 8 is held adjacent the member 12 regardless of the working surface 14 orientation. Transport paths are two or three-dimensional, as shown in Figures 14 and 15.

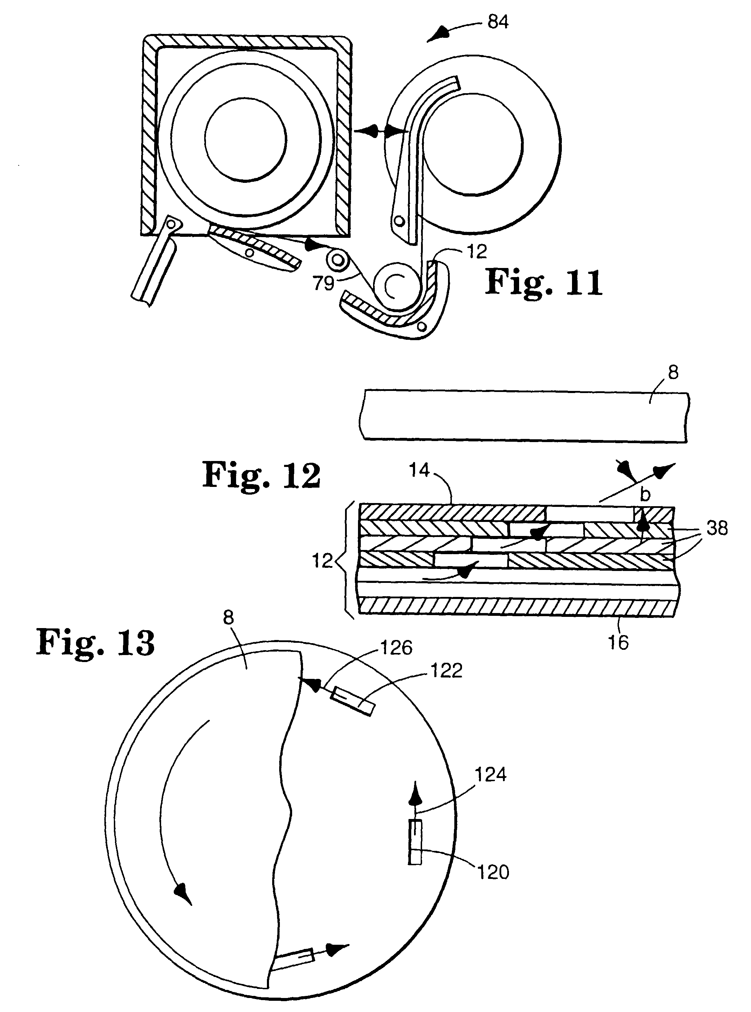

An acute angle b relative to the working surface 14 as shown in Figure 12, which rotates an article 8, is preferred. When used to transport articles 8, minimizing this angle and the fluid flow component perpendicular to the working surface 14 maximizes the component of fluid flow in the direction of travel.

The system 10 has been used with tape winders 78 and tape threaders 80, shown in Figures 9-11. The tape 79 will not contact the member 12 around bends due to the small outlet construction. For example, as shown in Figure 9, the member 12 has been used to thread movie film 81, supplied to the member 12 from a supply reel, through a projector's film path. After threading, stopping the air flow through the outlets 22 allows the film 81 to be used for projection. Similar principles have been applied to the use of the system 10 with data, video, and audio magnetic and optical tapes 79. The member 12 has been used to thread new reels of tape 79 into winders 78, as shown in Figure 10. The member 12 enables the tape 79 to be wound onto a reel without a leader. Also, as shown in Figure 11, the system has been used with single reel cartridges 84 to transport the tape 79 and connect the cartridge reel to the resident drive reel with the member 12. Several members 12 can be used together to transport wide tapes and webs. Gaps between adjacent members 12 can serve as vent passages for the transport fluid.

In another example embodiment, the transport system is formed of a layered construction using three layers. (All dimensions are approximate.) The first layer 52 is 0.4 mm thick and is made of a vinyl material with adhesive on one side to adhere to the second layer. The second layer 56 is 0.4 mm thick and also is made of a vinyl material. The second layer can have adhesive on both sides to adhere to the first and third layers. The third layer 60 is 0.1 mm thick and is made of stainless steel. The working surface 16 formed on the third layer 60 is 25 mm wide. This transport system has two arrays of orifices 19 and two arrays of outlets 20 are formed in the working surface 16. The outlets 20 are rectangular and have a width of 1.0 mm and length of 5.0 mm. The outlets are oriented at an angle with respect to a the centerline of the working surface of 30°. The outermost portion of the outlets 20 (from the centerline) is 3.5 mm from the side edge of the working surface, 14.0 mm from corresponding outlets on the other side of the centerline, and 12.0 mm from the outermost portion of the adjacent outlet on the same side of the centerline. The outlet creates an angular, nonlinear, stepped path for the fluid. This path causes fluid to exit the outlet at a 1° angle with the working surface. This angle is defined, referring to Figure 2, as the angle formed between the diagonal line connecting the lower left and upper right corners of the outlet 20 formed in the third layer 60 and the working surface 16. (The third layer 60 is 0.1 mm thick and the outlet length is 5 mm.)

A transport system 27 cm long formed in a loop and having 45 outlets was used to transport a flexible tape which was 25.4 cm long, 2.54 cm wide, 25.4 microns thick, and was 0.22 grams. The air mass flow rate entering the inlet in the first layer ranged from 0.0006 kg/sec to 0.0010 kg/sec (the air velocity ranged from 27 m/sec to 235 m/sec with the directional component ranging from 23 m/sec to 204 m/sec). This produced an air velocity at the outlet of up to 300 m/sec transported the article at speeds of up to 1650 cm/sec.

The member 12 can provide high velocity noncontact transport of die-cut flexible disks when extracting the disk from presses after die-cutting. Moreover, the air transport system removes loose debris. Support of the disk adjacent the working surface 14 allows the disk to be transferred from one member 12 conveyer to another for changing containers or article collection. By using both forward-propelling and reverse-propelling outlets 22, curl of the punched disk is reduced as a function of the pressure differential.

A variation of transporting is rotating the article 8 on the working surface 14. This is shown in Figures 12 and 13. Articles such as magnetic or optical disks with a conventional or non-conventional form factor have been used. Credit card-shaped media have been rotated and round media within credit card-shaped jackets can be rotated. Additionally, the system has been used as an air drive, with abrasive films to provide light sanding or polishing heads.

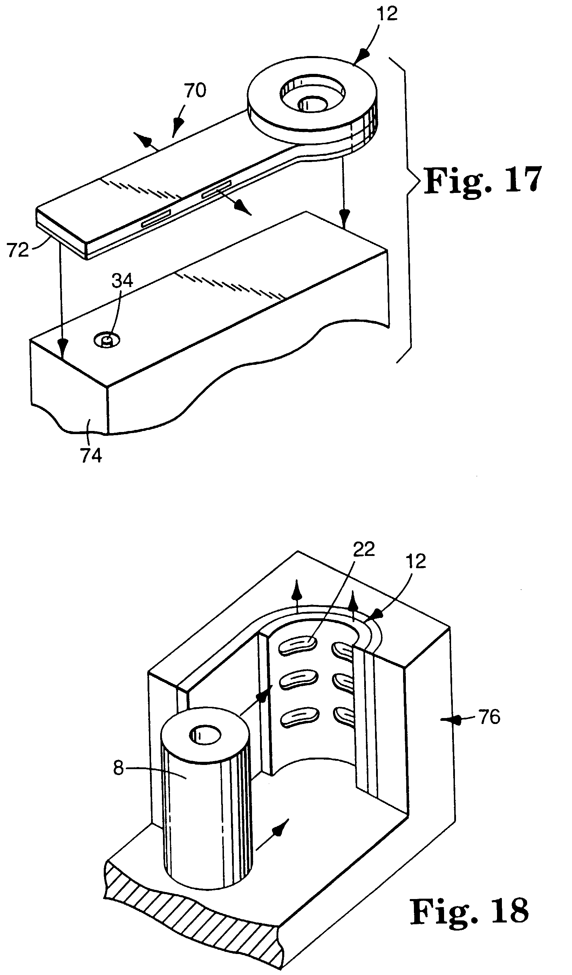

Alternatively, in a contact/hold-down embodiment, as shown in Figures 16-18, the system 10' has been used to orientation independently hold an article 8 in place on the working surface 14 while contacting the article 8. In this embodiment, after contact and establishing a vacuum, none of the fluid passes through the outlets 22 on the working surface 14. The fluid passes through the orifices 18 initially and exits through additional passages which serve as a vent 21. The combination of orifices 18 and vent 21 forms a complete path connected to the fluid source 36 and the resulting suction holds the article 8 against the working surface 14. The system 10' can be a suction cup 70, as shown in Figure 17, used to handle paper and components, and in part feeding applications. The suction cup has been adhered to a support block 74 using an adhesive layer 72. The system 10' also has been used as a process clamp 76, shown in Figure 18, to hold parts for process operations. The member 12 lines the walls of the process holding fixture. Also, a vacuum chuck using the system 10' can hold non-magnetic materials for milling, grinding, and engraving.

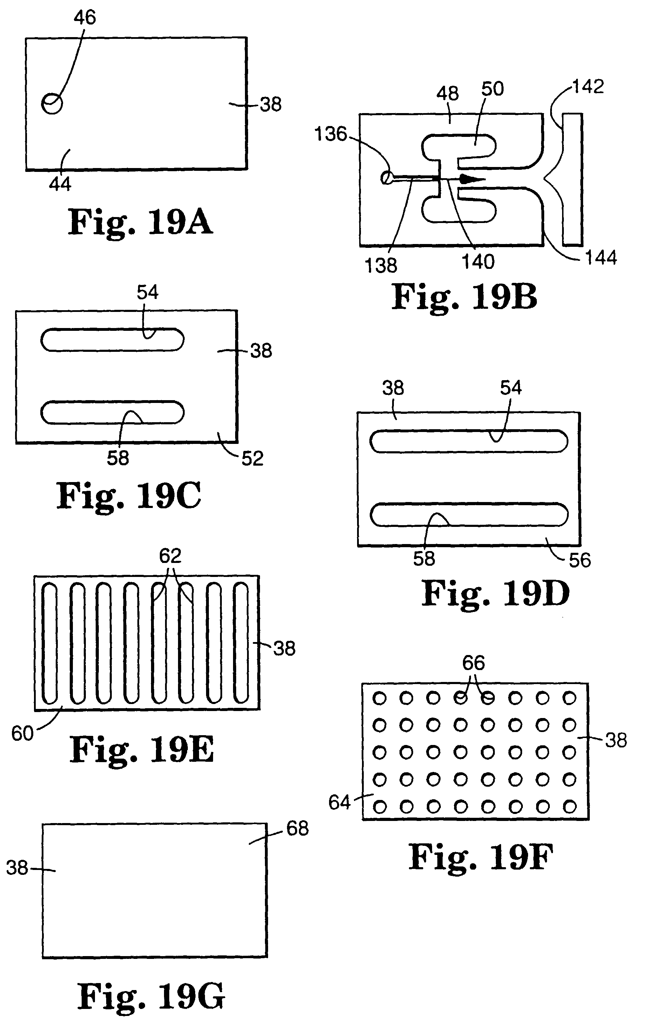

Figures 19A-19G illustrate the layers 38 of the member 12 configured for contact holding using vacuum as described with respect to Figures 16, 17, and 18. This embodiment uses a venturi layer to generate a partial vacuum. The first layer 44, shown in Figure 19A, is the inlet layer and includes an opening 46 which serves as the inlet 34. The second layer 48, shown in Figure 19B, is a venturi layer and includes an opening 50 which generates a partial vacuum. Air enters the venturi layer 48 at 136, passes through the nozzle portion 138 and gap 140, and exhausts at vents 142 and 144. The flow exiting the nozzle portion 138 reduces pressure in the gap 140. This low pressure is distributed through the remaining layers 52, 56, 60, 64 to the working surface layer 68.

The third and fourth layers 52, 56, shown in Figures 19C and 19D, respectively, include elongate openings 54, 58 which are generally oriented to distribute the air in the direction of flow. The fifth layer 60, shown in Figure 19E, includes elongate openings 62 which direct the air to the outlets 22. The sixth layer 64, shown in Figure 19F, includes openings 66 which serve as the outlets 22 through which the air exits the orifices 18 formed by the openings 50, 54, 58, 62. The seventh layer 68, shown in Figure 19G, is the porous, nonwoven working surface layer and covers and protects the member 12 from debris. The nonwoven web distributes the partial vacuum uniformly across the working surface 14 and permits fragile, highly polished, or cosmetic parts to be held for transport during manufacturing processes without damage. A plurality of independent laminate constructions as previously described has been assembled into an array of elements. Test partial vacuums have exceeded about 4.8 x 10⁴ pascal. In alternative embodiments, a vacuum source has been coupled to the layers 52, 56, 60, 64 to attain similar holding benefits.

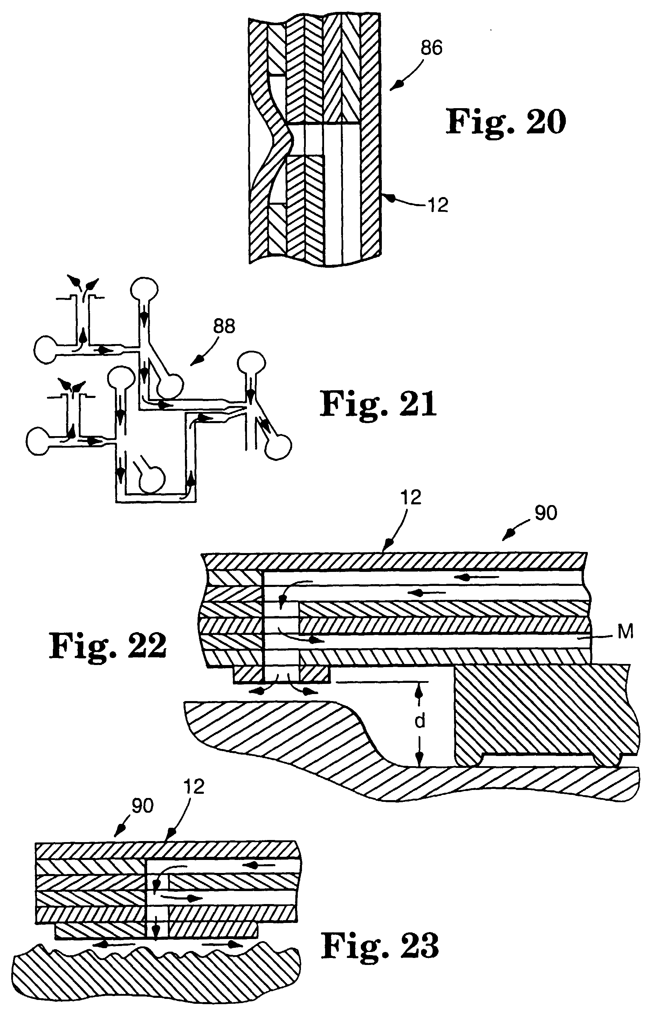

In another operation of the system 10, the orifices 18 can be oriented to serve as fluidic switches 86, shown in Figure 20 or logic elements 88, shown in Figure 21. The membrane switches can be made with materials similar to those used in electronic membrane switches such as PET and the like. The switches can be used to pilot air valves or to provide a logic and control function.

The system 10 also has served as inspection transducers 90, as shown in Figures 22 and 23. In Figure 22, the member 12 is used for dimensional air gauging. When the distance from an article to an outlet is less than one third of the diameter of the outlet, the pressure measured in the outlet is proportional to that distance. As the distance d decreases, flow from the outlet decreases, resulting in an increase in the pressure measured at m. In Figure 23, the member 12 is used for gauging a surface finish. The surface roughness of the material being tested acts as a flow restrictor. A rough microfinish creates turbulence, reduces the air flow and raises the pressure measured at the outlet. A polished surface promotes laminar flow with a resultant lower outlet pressure. The measured outlet pressure provides an analogue to the actual surface finish of the sample being tested.

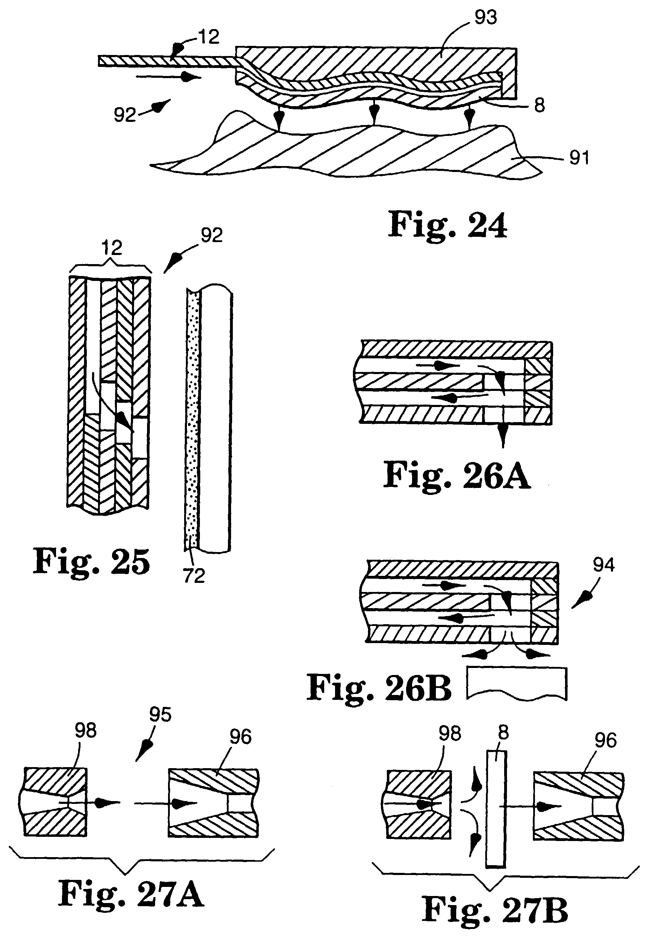

The system 10 also can be used, when attached to the appropriate tooling, as a tape applicator 92 to facilitate the application of tapes to products having complex contours. This is shown in Figure 24, which depicts decorative tape being applied to a product 91. A length of tape can be cut from a roll, fed into position by the member 12 attached to an application pad 93, and applied to the product by downward movement. In the loading position, the member 12 and pad 93 are lowered to press the tape against the product 91. Application begins at the tape edge and continues across the tape surface until the application is complete to prevent air entrapment. When the tape has been applied, the air supply is deactivated and the member 12 is raised. As the member 12 does not physically contact the tape being transported and applied, adhesive tapes can be transported with the adhesive layer 72 facing the member 12, as shown in Figure 25.

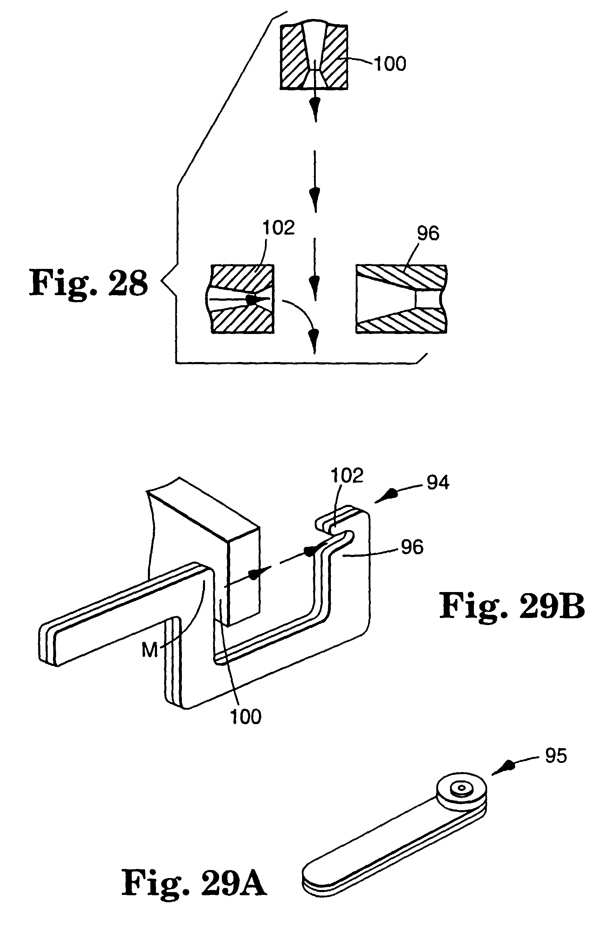

The operation also has been used to sense the presence of an article 8, as illustrated in Figures 26-29. Figure 26 shows a back pressure article sensor 94. When air exits from the outlet 22 the resultant pressure measured at the control interface near the outlet 22 is low. When an object placed near the outlet impedes flow, the interface pressure increases to signal the presence of the object as shown in Figure 26B. Figure 27 operates on an interruptable air flow principle. Two systems 10 are separated by a gap with the orifices 18 on each member 12 oriented to permit fluid exiting the outlets 22 to contact and sense the presence of an article 8 between the systems. The pressure in the receiver system 96 drops when the article 8 is between the sender system 98 and the receiver system 96. In Figure 28, the range of this interruptable air flow system is increased by using a cross-fire technique. A second sender system 100 ejects air into the stream between the first sender system 102 and the receiver system 96 and the sensing gap extends from the outlet 22 of the second sender system 100 to the sides of the first sender and receiver systems 102, 96. The flow from the second sender system 100 normally diffuses the first sender air flow. When an article 8 is present, the flow from the second sender system 100 is interrupted, and the pressure at the receiver system 96 increases. Figure 29A is a perspective view of the sensor 94 of Figure 26 and Figure 29B is a perspective view of the sensor 95 of Figure 27. The sensor body can be attached to an existing surface. A supply manifold in the sensor body provides air flow and a passage sends a pressure build-up signal to a control system when an object is close to the sensing port.

The system 10 has been used to convert an existing surface into a system for handling and operating on an article 8 by adhering to the existing surface. The converted surface with the system 10 has a thickness that is only slightly thicker than the unconverted surface. Thus, surfaces can be converted inexpensively and quickly. Where the existing surface to be converted is a fluid supply manifold, holes can be formed in the surface of the manifold to communicate with the orifices 18, as shown in Figure 2.

The method of handling and operating on an article 8 includes the steps of placing the article 8 n the working surface 14 and passing fluid through the orifices 18 to handle and operate on the article 8.

## Claims

1. An apparatus for handling and operating on an article (8) comprising a member (12) having a working surface (14), an opposing surface (16), and at least one orifice (18) beginning from at least one inlet (34), passing through the member (12), and having at least one outlet (22) on the working surface (14) to permit a fluid to enter the member (12) through the inlet (34) and pass through the orifice (18), wherein the fluid passing through the orifice (18) handles and operates on an article (8) located adjacent the working surface (14) while preventing the article (8) from contacting the working surface (14), wherein the member (12) is a web comprising a plurality of stacked layers (38) connected to each other along their major surfaces, and wherein the working surface (14) comprises the outer major surface of one of the outer stacked layers (38),
**characterized in that**
each layer (38) is provided with at least one throughhole connecting the major surfaces thereof and extending substantially perpendicularly thereto, the openings of each throughhole being in the respective plane of the major surfaces of each respective layer.

2. The apparatus of claim 1, wherein the orifice (18) is non-uniform and nonlinear to create an angular, non-linear, stepped path for the fluid.

3. The apparatus of claim 1, wherein the member (12) is flexible and the plurality of stacked layers (38) forms a laminate.

4. The apparatus of claim 3, further comprising a fluid source (36) connected to the inlet (34) of the web, means for controlling the fluid from the fluid source (36) to the web and through the web to control the dynamics of the article (8).

5. The apparatus of claim 1, wherein the orifice (18) is oriented to cause the fluid to exit the orifice (18) through the outlet (22) and the orifice (18) and outlet (22) are configured to transport the article (8) along the working surface (14).

6. The apparatus of claim 1, wherein the orifice (18) is oriented to cause the fluid to exit the orifice (18) through the outlet (22) and the orifice (18) and outlet (22) are configured to rotate the article (8) adjacent the working surface (14).

7. The apparatus of claim 1, wherein the fluid exits through the outlet (22), and wherein the orifice (18) and outlet (22) are oriented to cause the fluid exiting the orifice outlets (22) to orientation independently hold the article (8) located adjacent the working surface (14) while preventing the article (8) from contacting the working surface (14).

8. The apparatus of claim 7, wherein the orifice (18) is oriented to cause the fluid to exit the orifice (18) through the outlet (22) and is directed and shaped to transport the article (8) along the working surface (14).

9. The apparatus of claim 1, wherein the orifice (18) is oriented to cause the fluid exiting the orifice (18) to create a pressure differential between the article (8) and the working surface (14) to orientation independently hold the article (8) adjacent the working surface (14).

10. Use of an apparatus of any one of the preceding claims for converting an existing surface into a system (10) for handling and operating on an article .(8) wherein the member (12) comprises at least one side connecting the working surface (14) and the opposing surface (16).

11. Use of an apparatus of claim 10, wherein the orifice (18) is oriented to cause the fluid exiting the orifice (18) to create a pressure differential between the article (8) and the working surface (14) to orientation independently hold the article (8) adjacent the working surface (14).

## Patentansprüche

1. Vorrichtung zum Handhaben und Behandeln eines Artikels (8), mit einem Teil (12), das eine Arbeitsfläche (14), eine gegenüberliegende Fläche (16) und mindestens einen Durchlaß (18) aufweist, der an mindestens einem Einlaß (34) beginnt, durch das Teil (12) hindurch verläuft und mindestens einen Auslaß (22) an der Arbeitsfläche (14) aufweist, um ein Fluid durch den Einlaß (34) in das Teil (12) eintreten zu lassen und durch den Durchlaß (18) hindurchtreten zu lassen, wobei das durch den Durchlaß (18) hindurchtretende Fluid einen nahe der Arbeitsfläche (14) befindlichen Artikel (8) handhabt und auf diesen einwirkt und dabei den Artikel (8) daran hindert, die Arbeitsfläche (14) zu kontaktieren, wobei das Teil (12) eine Bahn mit mehreren aufeinanderliegenden Schichten (38) ist, die über ihre Hauptflächen miteinander verbunden sind und wobei die Arbeitsfläche (14) die äußere Hauptfläche einer der äußeren aufeinanderliegenden Schichten (38) ist,
**dadurch gekennzeichnet**,
daß in jeder Schicht (38) mindestens ein Durchgangsloch ausgebildet ist, das die Hauptflächen dieser Schicht miteinander verbindet und sich im wesentlichen rechtwinklig zu der Schicht erstreckt, wobei die Durchlässe jedes Durchgangsloches jeweils in der Ebene der Hauptflächen der jeweiligen Schicht angeordnet sind.

2. Vorrichtung nach Anspruch 1, bei der der Durchlaß (18) nichtgleichförmig und nichtlinear ist, um einen winkligen, nichtlinearen, stufenweisen Weg für das Fluid zu bilden.

3. Vorrichtung nach Anspruch 1, bei der das Teil (12) flexibel ist und die mehreren aufeinanderliegenden Schichten (38) ein Laminat bilden.

4. Vorrichtung nach Anspruch 3, ferner mit einer Fluidquelle (36), die mit dem Einlaß (34) der Bahn verbunden ist, und mit einer Einrichtung, die das aus der Fluidquelle (36) ausgegebene und zu der Bahn und durch die Bahn strömende Fluid steuert, um die Dynamik des Artikels (8) zu steuern.

5. Vorrichtung nach Anspruch 1, bei der der Durchlaß (18) derart ausgerichtet ist, daß das Fluid den Durchlaß durch den Auslaß (22) hindurch verläßt, und der Durchlaß (18) und der Auslaß (22) derart konfiguriert sind, daß sie den Artikel (8) entlang der Arbeitsfläche (14) transportieren.

6. Vorrichtung nach Anspruch 1, bei der der Durchlaß (18) derart ausgerichtet ist, daß das Fluid den Durchlaß durch den Auslaß (22) hindurch verläßt, und der Durchlaß (18) und der Auslaß (22) derart konfiguriert sind, daß sie den Artikel (8) nahe der Arbeitsfläche (14) in Rotation versetzen.

7. Vorrichtung nach Anspruch 1, bei der das Fluid durch den Durchlaß (22) austritt und bei der der Durchlaß (18) und der Auslaß (22) derart ausgerichtet sind, daß das aus den Auslässen (22) austretende Fluid den an der Arbeitsfläche (14) befindlichen Artikel (8) orientierungsunabhängig hält und dabei den Artikel (8) daran hindert, die Arbeitsfläche (14) zu kontaktieren.

8. Vorrichtung nach Anspruch 7, bei der der Durchlaß (18) derart ausgerichtet ist, daß das Fluid den Durchlaß durch den Auslaß (22) hindurch verläßt, und der Durchlaß (18) derart ausgerichtet und geformt ist, daß er den Artikel (8) entlang der Arbeitsfläche (14) transportiert.

9. Vorrichtung nach Anspruch 1, bei der der Durchlaß (18) derart ausgerichtet ist, daß er das aus dem Durchlaß (18) austretende Fluid dazu veranlaßt, einen Differenzdruck zwischen dem Artikel (8) und der Arbeitsfläche (14) zu erzeugen, um den Artikel (8) orientierungsunabhängig an der Arbeitsfläche (14) zu halten.

10. Verwendung einer Vorrichtung nach einem der vorhergehenden Ansprüche zur Umrüstung einer existierenden Oberfläche in ein System (10) zum Handhaben und Behandlen eines Artikels (8), wobei das Teil (12) mindestens eine Seite aufweist, die die Arbeitsfläche (14) mit der gegenüberliegenden Fläche (16) verbindet.

11. Verwendung einer Vorrichtung gemäß Anspruch 10, bei der der Durchlaß (18) derart ausgerichtet ist, daß er das aus dem Durchlaß (18) austretende Fluid dazu veranlaßt, einen Differenzdruck zwischen dem Artikel (8) und der Arbeitsfläche (14) zu erzeugen, um den Artikel (8) orientierungsunabhängig an der Arbeitsfläche (14) zu halten.

## Revendications

1. Un appareil pour manutentionner un article (8) et opérer sur lui comprenant un organe (12) ayant une surface de travail (14), une surface opposée (16) et au moins un orifice (18) commençant à partir d'au moins une entrée (34) passant à travers l'organe (12) et ayant au moins une sortie (22) sur la surface de travail (14) pour permettre à un fluide d'entrer dans l'organe (12) par l'entrée (34) et de passer à travers l'orifice (18), dans lequel le fluide passant à travers l'orifice (18) manutentionne un article (8) disposé adjacent à la surface de travail (14) et opère sur lui tout en empêchant l'article d'entrer en contact avec la surface de travail (14), dans lequel l'organe (12) est un feuillet comprenant plusieurs couches empilées (38) assemblées entre elles suivant leur grandes surfaces et dans lequel la surface de travail (14) comprend la grande surface extérieure d'une des couches extérieures empilées (38),
caractérisé en ce que
chaque couche (38) est munie d'au moins un trou traversant reliant entre elles ses grandes surfaces et s'étendant sensiblement perpendiculairement à ces dernières, les ouvertures de chaque trou traversant étant situées dans les plans respectifs des grandes surfaces de chaque couche respective.

2. L'appareil de la revendication 1, dans lequel l'orifice (18) est non uniforme et non linéaire pour créer un trajet anguleux, non linéaire, en gradins pour le fluide.

3. L'appareil de la revendication 1, dans lequel l'organe (12) est flexible et la série de couches empilées (38) forme un stratifié.

4. L'appareil de la revendication 3, comprenant, en outre, une source de fluide (36) raccordée à l'entrée (34) du feuillet, des moyens pour commander l'écoulement du fluide de la source de fluide (36) jusqu'au feuillet et à travers le feuillet afin de commander la dynamique de l'article (8).

5. L'appareil de la revendication 1, dans lequel l'orifice (18) est orienté de façon telle que le fluide quitte l'orifice (18) par la sortie (22) et l'orifice (18) et la sortie (22) ont des configurations appropriées pour transporter l'article (8) le long de la surface de travail (14).

6. L'appareil de la revendication 1, dans lequel l'orifice (18) est orienté de façon telle que le fluide quitte l'orifice (18) par la sortie (22) et l'orifice (18) et la sortie (22) ont des configurations appropriées pour faire tourner l'article (8) dans une disposition adjacente à la surface de travail (14) .

7. L'appareil de la revendication 1, dans lequel le fluide sort par la sortie (22) et dans lequel l'orifice (18) et la sortie (22) sont orientés de façon telle que le fluide sortant des sorties (22) des orifices maintient l'article (8) en place dans une disposition adjacente à la surface de travail (14) indépendamment de l'orientation, tout en empêchant l'article (8) d'entrer en contact avec la surface de travail (14).

8. L'appareil de la revendication 7, dans lequel l'orifice (18) est orienté de façon telle que le fluide sort de l'orifice (18) par la sortie (22) et est dirigé et configuré pour transporter l'article (8) le long de la surface de travail.

9. L'appareil de la revendication 1, dans lequel l'orifice (18) est orienté de façon telle que le fluide sortant de l'orifice (18) crée une pression différentielle entre l'article (8) et la surface de travail (14) pour maintenir l'article (8) en place indépendamment de l'orientation dans une disposition adjacente à la surface de travail (14).

10. Utilisation d'un appareil selon l'une quelconque des revendications précédentes pour convertir une surface existante en un système (10) pour manutentionner un article (8) et opérer sur lui, dans laquelle l'organe (12) comprend au moins un côté reliant la surface de travail (14) et la surface opposée (16).

11. Utilisation d'un appareil selon la revendication 10, dans laquelle l'orifice (18) est orienté de façon telle que le fluide sortant de l'orifice (18) crée une pression différentielle entre l'article (8) et la surface de travail (14) pour maintenir l'article en place dans une disposition adjacente à la surface de travail (14) indépendamment de l'orientation.
